# EUROPÄISCHE PATENTSCHRIFT

(11) **EP 0 438 753 B1**
(45) Veröffentlichungstag und Bekanntmachung des Hinweises auf die Patenterteilung: **15.11.1995**
(21) Anmeldenummer: 90125076.1
(22) Anmeldetag: 21.12.1990
(51) Int. Cl.: G06F 11/00, G11C 5/00, G11C 16/06, H05K 7/10

(54) **Schaltung zum Ersetzen eines EPROMs**
Circuit for replacing an EPROM
Circuit pour le remplacement d'une EPROM

(30) Priorität: 15.01.1990 DE 4000943
(43) Veröffentlichungstag der Anmeldung: 31.07.1991
(73) Patentinhaber: Ruge, Wolfgang, Dr., D-47877 Willich (DE)
(72) Erfinder: Ruge, Wolfgang, Dr., D-47877 Willich (DE)
(74) Vertreter: Goddar, Heinz J., Dr.

(56) Entgegenhaltungen:
- EP-A- 0 164 949
- WO-A-80/00383
- CH-A- 665 060
- APPLIED OPTICS. Bd. 28, Nr. 8, 15. April 1989, New York, US; Seite 1446; F.S. HARRIS: "NASA Patter"
- WESCON TECHNICAL PAPERS. Bd. 88, Nr. 32, November 1988, North Hollywood, US; A.SEN: "A Versatile Seven Chip Controller Board", Seiten SS/4, 1-8

## Beschreibung

Die Erfindung betrifft eine Schaltung zum Ersetzen eines EPROMs nach dem Oberbegriff des Patentanspruches 1.

Die Erfindung betrifft eine Schaltung zum Ersetzen eines EPROMs während des Erstellens und Testens des auf dem EPROM zu speichernden bzw. gespeicherten Programms, die einen Schreib/Lese-Speicher, eine Steuerung, eine Schnittstelle und eine Kopplungs-/Entkopplungseinrichtung umfaßt.

Datenverarbeitungsanlagen benötigen Programme, um die ihnen zur Verfügung gestellten Daten in der vom Anwender gewünschten Weise zu verarbeiten. Die Programme sind häufig in EPROMs gespeichert. Das bedeutet, daß die EPROMs bzw. die Programme zuerst getestet werden müssen, bevor die Programme endgültig auf den EPROMs gespeichert werden können. Die Programmierung von EPROMs erfolgt gemäß folgendem Schema:
Das Programm wird befehlsmäßig in der entsprechenden Sprache zusammengestellt,
das Programm wird in den entsprechenden Maschinencode übersetzt,
der Maschinencode wird in einem oder mehreren EPROM(s) gespeichert,
war das EPROM bereits programmiert, muß es vorher gelöscht werden,
das EPROM wird in die Datenverarbeitungsanlage eingesetzt,
das Programm wird getestet.

Ein solcher Zyklus wird so lange durchlaufen, bis die Datenverarbeitungsanlage mit dem Programm einwandfrei arbeitet.

Da es bei etwaig auftretenden Fehlern zur Korrektur des auf dem EPROM gespeicherten Programmes erforderlich ist, das EPROM auszubauen, in ein dafür vorgesehenes externes Gerät einzubauen, zu löschen und neu zu programmieren, ist das vorstehend beschriebene Verfahren sehr zeitaufwendig und kostspielig. Darüber hinaus leidet das jeweilige EPROM auch bei größter Sorgfalt dadurch, daß es häufig ein- und ausgebaut werden muß.

Es ist versucht worden, die dargestellten Probleme dadurch zu lösen, daß die Programme über externe Geräten getestet werden, welche sich anderer Speicherarten (z.B. RAM) bedienen, wobei das Programm erst dann in das eigentliche EPROM gespeichert wird, wenn die Tests über das externe Gerät erfolgreich abgeschlossen sind.

Hierbei ergibt sich jedoch das Problem, daß die Daten von dem externen Gerät der betreffenden Datenverarbeitungsanlage zur Verfügung gestellt werden müssen. Eine solche Datenübertragung erfolgt über vielpoliges Kabel (z.B. ein 28-poliges Flachkabel beim "Ersatz" eines EPROM vom Typ 27 128 oder 27 256), welches naturgemäß störanfällig ist, so daß nicht in jedem Fall sicher davon ausgegangen werden kann, daß das Programm in der Datenverarbeitungsanlage während der Tests einwandfrei arbeitet.

Auch führte es nicht zu dem gewünschten Erfolg, das zu programmierende EPROM während der Programmier- und Testphase durch ein batteriegepuffertes RAM zu ersetzen und letzteres in einem externen Gerät zu programmieren, weil dadurch zwar die störanfällige Datenübertragung per Kabel fortfällt, der RAM-Speicher jedoch für jeden einzelnen Testlauf aus dem externen Programmier-Gerät herausgenommen und in die Datenverarbeitungsanlage eingesetzt werden muß. Zum einen leidet dadurch der RAM-Speicher, zum anderen ist dieses Verfahren ebenfalls sehr zeitaufwendig und kostspielig.

Aus der Zeitschrift "Elektor", 12/1987, Seiten 58 - 63, ist eine Schaltung der eingangs genannten Art bekannt. Bei dieser Schaltung sind zwei Flachbandkabel vorgesehen, wobei das eine auf eine Centronics-Press-Buchse eines Programmierrechners und das andere an die Fassung für das zu Programmierende EPROM geht. Der Anschlup der Schaltung an den EPROM-Sockel über das Flachbandkabel führt zu dem Nachteil, daß Störungen auftreten können, weshalb nicht in jedem Fall sicher davon ausgegangen werden kann, daß das Programm während des Testes einwandfrei arbeitet.

Der Erfindung liegt demzufolge die Aufgabe zugrunde, eine Schaltung der eingangs genannten Art zu schaffen, die nicht störanfällig ist.

Erfindungsgemäß wird diese Aufgabe durch das im Kennzeichen des Patentanspruches 1 genannte Merkmal gelöst.

Die Unteransprüche betreffen besondere Ausführungsformen der Erfindung.

Mittels der seriellen Verschaltung läßt sich der Adreßbereich eines einzelnen Speichers erheblich ausweiten bzw. auf großere Adreßbereiche aufteilen. Durch die parallele Verschaltung ensteht ein System mit einer größeren Datenbusbreite (z.B. n * 8 Bit). Die letztere Variante ist unter anderem für den Einsatz in Signalprozessoren interessant, deren Busbreite herstellerabhängig stark schwankt. Sie ist aber auch bei modernen 32- und 64-Bit-Rechnern in Erwägung zu ziehen.

Die überspielten Daten werden je nach eingestelltem Modus
auf ein einziges System gespielt oder
auf mehrere Systeme (Sockel) verteilt, und zwar
als 8 Bit-Version über einen größeren Adreßbereich auf mehrere "EPROMs" verteilt oder
als n * 8 Bit-Version in einer größeren Datenbusbreite als 8 Bit.

Die Realisierung der erfindungsgemäßen Schaltung kann in Form einer Dickschichtschaltung oder von Gate Arrays, kundenspezifischen Schaltungen und dergleichen erfolgen. Letztere müssen jedoch so intelligent sein, daß sie die erforderlichen Schnittstellen bedienen können.

Die erfindungsgemäße Schaltung erhält eine eigene Adresse (z.B. 3 Bit). Damit läßt sich auch bei mehreren Einheiten jede eindeutig identifizieren. Die Adresse verweist auf den entsprechenden Adressenbereich der erfindungsgemäßen Schaltung (des zu programmierenden EPROMs).

Die Steuerung verteilt anhand dieser Informationen und der EPROM-Größe automatisch den eingehenden Datenstrom auf die einzelnen Ersatzspeicher.

Im 8-Bit-Modus geschieht die Verteilung der Daten dergestalt, daß alle Daten hintereinander im Speicher abgelegt werden. Ist der Speicher voll, so ist eine weitere erfindungsgemaße Schaltung erforderlich, welche die Restdaten übernimmt.

Im Verkettungsmodus werden die eingehenden Daten zyklisch auf mehrere Systeme aufgeteilt, wie es bei einem 16-Bit- oder 32-Bit-System (oder auch mit anderen Bitbreiten) üblich ist. Dadurch ergeben sich Vorteile bei der Programmerstellung für Mikroprozessoren größerer Datenbusbreite oder für andere Rechner mit Nicht-Standard-Busbreiten, wie sie in manchen Signalprozessoren zu finden sind.

Die erfindungsgemäße Schaltung ist so ausgelegt, daß sie bestimmte EPROMs (z.B. 8- oder 16-Bit-Typen) direkt nachbilden kann. Erforderlichenfalls können auch andere Typen simuliert werden, auch im Page-Modus.

Die Startadresse eines EPROMs und dessen "Größe" bestimmen, welche Daten übernommen werden. Werden mehrere hintereinanderliegende EPROMs ersetzt, wird jeder der dafür erforderlichen erfindungsgemäßen Schaltung eine eigene Startadresse zugeordnet.

Der 8/16-Bit-Modus ist für gängige Mikroprozessortypen gedacht. Nach einer bevorzugten Ausführungsform der erfindungsgemäßen Schaltung ist an der Schaltung ein Schalter vorgesehen, mit Hilfe dessen eingestellt werden kann, ob die Schaltung die eingehenden Daten bei gerader oder bei ungerader Adresse übernehmen soll.

Der Verkettungsmodus erlaubt eine beliebige Parallelschaltung von mehreren erfindungsgemäßen Schaltungen. Dadurch lassen sich gewünschtenfalls 8-, 16-, 32- oder 64-Bit ansteuern. Andere Konstellationen sind ebenfalls denkbar.

Nachstehend ist die Erfindung anhand eines bevorzugten Ausführungsbeispiels mit weiteren Einzelheiten näher erläutert. Es zeigen:
- Fig. 1: schematisch die Verschaltung der einzelnen Elemente einer besonders bevorzugten Ausführungsform der erfindungsgemaßen Schaltung und
- Fig. 2: schematisch eine Draufsicht auf die Schaltung nach Fig. 1.

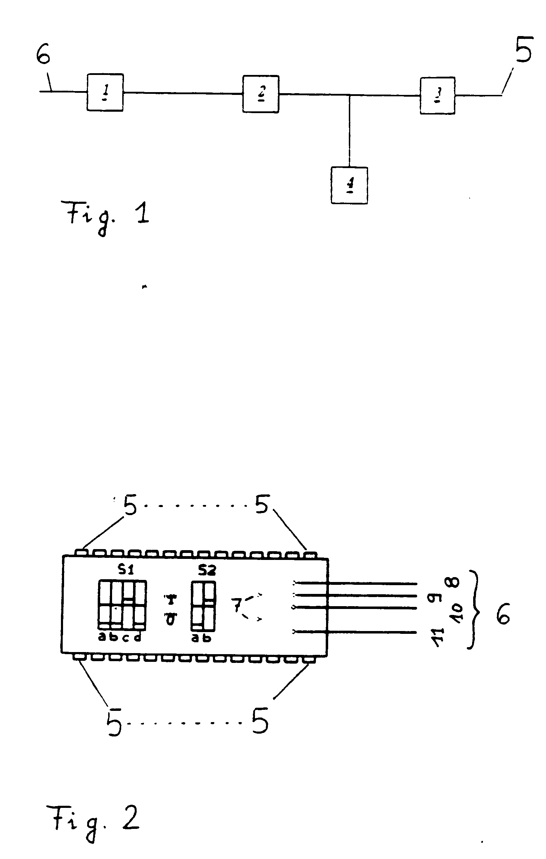

In Figur 1 ist mit 1 eine serielle Schnittstelle bezeichnet, an die ein Mikroprozessor 2 angeschlossen ist. Der Mikroprozessor 2 trägt ein Programm. Er bedient sich während des Testens eines Arbeitsspeichers 4, der nach der hier beschriebenen Ausführungsform von einem statischen RAM gebildet ist.

Mit 3 sind abschaltbare Bustreiber bezeichnet, welche zusammen mit Anschlüssen 5 die Verbindung zu dem für das zu testende EPROM vorgesehenen Sockel darstellen.

Über die Schnittstelle 1 und einen entsprechenden Anschluß 6 erfolgt zum einen die anfängliche Speisung der Schaltung mit Daten und zum anderen die Spannungsversorgung.

Die Spannungsversorgung kann aber auch von der Datenverarbeitungsanlage selbst her oder über eine in der erfindungsgemäßen Schaltung befindliche Batterie erfolgen.

In Figur 2 sind die einzelnen Pins mit dem Bezugszeichen 5 bezeichnet. Sie entsprechen der Verbindung 5 zum EPROM-Sockel in Figur 1.

Oben auf der erfindungsgemäßen Schaltung befinden sich zwei Schaltergruppen S₁ und S₂, die vier Schalter a, b, c, d bzw. zwei Schalter a, b umfassen. Je nach dem, ob die einzelnen Schalter in der Stellung "1" oder "0" stehen, ist einer der folgenden Modi eingestellt, in dem die Schaltung gerade betrieben wird: Adressvorgabe-, 8/16 Bit-, Übertragungs- und Verkettungs-Modus.

Ferner sind oben auf der Schaltung zwei LED 7 vorgesehen. Diese dienen zum Anzeigen des Betriebszustandes der Schaltung.

In Figur 2 auf der rechten Seite sind vier Anschlußleitungen 8, 9, 10 und 11 dargestellt. Es handelt sich bei diesen Leitungen um die Anschlüsse für die anfängliche Datenübertragung sowie die Energieversorgung. Sie sind in Figur 1 global mit dem Bezugszeichen 6 bezeichnet. Im einzelnen sind mit 8 und 9 Datenleitungen bezeichnet, während die Leitungen 10 und 11 das 0-Potential bzw. 5 Volt führen.

## Patentansprüche

1. Schaltung zum Ersetzen eines EPROMs während des Erstellens und Testens des auf dem EPROM zu speichernden bzw. gespeicherten Programms, die Anschlüsse (5) zum Sockel des EPROMs, einen Schreib/Lese-Speicher (4), eine Schnittstelle (1) zur Dateneingabe in den Schreib/Lese-Speicher, eine Kopplungs-/Entkopplungseinrichtung (3) zum Anlegen der Daten des Schreib/Lese-Speichers an die genannten Anschlüsse und eine Steuerung (2) zur Steuerung der Schnittstelle und der Kopplungs-/Entkopplungseinrichtung umfaßt, dadurch gekennzeichnet, daß sie in ihren äußeren Abmessungen so gestaltet ist, daß sie in den für das zu ersetzende EPROM vorgesehenen Sockel direkt einsteckbar ist.

2. Schaltung nach Anspruch 1, dadurch gekennzeichnet, daß der Schreib/Lese-Speicher (4) ein RAM ist.

3. Schaltung nach Anspruch 1, dadurch gekennzeichnet, daß der Schreib/Lese-Speicher (4) ein EPROM ist.

4. Schaltung nach einem der vorangehenden Ansprüche, dadurch gekennzeichnet, daß die Steuerung(2) von einem Mikroprozessor gebildet ist.

5. Schaltung nach einem der vorangehenden Ansprüche, dadurch gekennzeichnet, daß die Steuerung (2) von einem Mikrocontroller gebildet ist.

6. Schaltung nach einem der vorangehenden Ansprüche, dadurch gekennzeichnet, daß die Schnittstelle (1) eine serielle Schnittstelle ist.

7. Schaltung nach einem der vorangehenden Ansprüche, dadurch gekennzeichnet, daß die Schnittstelle (1) eine parallele Schnittstelle ist.

8. Schaltung nach einem der vorangehenden Ansprüche, dadurch gekennzeichnet, daß die Kopplungs-/Entkopplungseinrichtung (3) von mindestens einem Multiplexer gebildet ist.

9. Schaltung nach einem der vorangehenden Ansprüche, dadurch gekennzeichnet, daß die Kopplungs-/Entkopplungseinrichtung (3) von mindestens einem (abschaltbaren) Bustreiber gebildet ist.

10. Schaltung nach einem der vorangehenden Ansprüche, dadurch gekennzeichent, daß sie wahlweise in einem Areßvorgabe-, einem 8 / 16 Bit-, einem Übertragungs- und einem Verkettungs-Modus betreibbar ist.

11. Schaltung nach Anspruch 10, gekennzeichnet durch eine oder mehrere Schalteinrichtung(en) (S₁, S₂) zum Einstellen der Betriebsart.

## Claims

1. A circuit for replacing an EPROM during the compilation and testing of the program already stored or to be stored on the EPROM, the circuit comprising connections (5) to the base of the EPROM, a read/write memory (4), an interface (1) for inputting data into the read/write memory, a coupler/de-coupler (3) for applying the read/write memory data to the said connections, and a control means (2) for controlling the interface and the coupler/de-coupler, characterised in that its outer dimensions are so devised that it can be plugged directly into the base provided for the EPROM for replacement.

2. A circuit according to Claim 1, characterised in that the read/write memory (4) is a RAM.

3. A circuit according to Claim 1, characterised in that the read/write memory (4) is an EPROM.

4. A circuit according to any one of the preceding claims, characterised in that the control means (2) is formed by a microprocessor.

5. A circuit according to any one of the preceding claims, characterised in that the control means (2) is formed by a microcontroller.

6. A circuit according to any one of the preceding claims, characterised in that the interface (1) is a serial interface.

7. A circuit according to any one of the preceding claims, characterised in that the interface (1) is a parallel interface.

8. A circuit according to any one of the preceding claims, characterised in that the coupler/decoupler (3) is formed by at least one multiplexer,

9. A circuit according to any one of the preceding claims, characterised in that the coupler/decoupler (3) is formed by at least one (disconnectable) bus driver.

10. A circuit according to any one of the preceding claims, characterised in that it is adapted to be operated optionally in an RS standard, an 8/16 bit, a transmission, and a concatenation mode.

11. A circuit according to Claim 10, characterised by one or more switching means (S₁, S₂) for adjusting the mode.

## Revendications

1. Circuit pour remplacer une mémoire morte programmable électriquement lors de la création et du contrôle du programme à enregistrer ou enregistré sur la mémoire morte programmable électriquement, comprenant des connexions (5) avec le socle de la mémoire morte programmable électriquement, une mémoire de lecture/écriture (4), une interface (1) pour entrer des données dans la mémoire de lecture/écriture, un dispositif de couplage/découplage (3) pour transmettre les données de la mémoire de lecture/écriture auxdites connexions, et un dispositif de commande (2) pour commander l'interface et le dispositif de couplage/découplage, caractérisé en ce que ledit circuit présente des dimensions extérieures permettant de l'enficher directement dans le socle prévu pour la mémoire morte programmable électriquement que l'on veut remplacer.

2. Circuit selon la revendication 1, caractérisé en ce que la mémoire de lecture/écriture (4) est une mémoire vive.

3. Circuit selon la revendication 1, caractérisé en ce que la mémoire de lecture/écriture (4) est une mémoire morte programmable électriquement.

4. Circuit selon l'une des revendications précédentes, caractérisé en ce que le dispositif de commande (2) est formé par un microprocesseur.

5. Circuit selon l'une des revendications précédentes, caractérisé en ce que le dispositif de commande (2) est formé par un microcontrôleur.

6. Circuit selon l'une des revendications précédentes, caractérisé en ce que l'interface (1) est une interface série.

7. Circuit selon l'une des revendications précédentes, caractérisé en ce que l'interface (1) est une interface parallèle.

8. Circuit selon l'une des revendications précédentes, caractérisé en ce que le dispositif de couplage/découplage (3) est formé par au moins un multiplexeur.

9. Circuit selon l'une des revendications précédentes, caractérisé en ce que le dispositif de couplage/découplage (3) est formé par au moins un circuit de commande (blocable).

10. Circuit selon l'une des revendications précédentes, caractérisé en ce qu'il peut fonctionner au choix en mode d'affectation d'adresse, en mode 8/16 bits, en mode de transmission et en mode de chaînage.

11. Circuit selon la revendication 10, caractérisé en ce qu'il comprend un ou plusieurs dispositif(s) de commutation (S₁, S₂) permettant de sélectionner le mode de fonctionnement.
